Europäisches Patentamt

European Patent Office

Office européen des brevets

(19)

(11) Publication number: **0 289 686 B1**

## EUROPEAN PATENT SPECIFICATION

(12)

(45) Date of publication of patent specification: **22.01.92**  (51) Int. Cl.⁵: **H05K  7/20**, H05K 7/14

(21) Application number: **87630083.1**

(22) Date of filing: **07.05.87**

(54) **Spring loaded multi-wedge card retainer.**

(43) Date of publication of application:
**09.11.88 Bulletin  88/45**

(45) Publication of the grant of the patent:
**22.01.92 Bulletin  92/04**

(84) Designated Contracting States:
**DE IT**

(56) References cited:
**GB-A- 2 103 020       GB-A- 2 164 803**
**US-A- 4 298 904       US-A- 4 318 157**
**US-A- 4 414 605       US-A- 4 480 287**

(73) Proprietor: **UNITED TECHNOLOGIES CORPO-
RATION**
**United Technologies Building 1, Financial
Plaza**
**Hartford, CT 06101(US)**

(72) Inventor: **McNulty, Christopher Thomas**
**45 Prospect Street**
**Terryville Connecticut 06786(US)**

(74) Representative: **Weydert, Robert**
**OFFICE DENNEMEYER S.à.r.l. P.O. Box 1502**
**L-1015 Luxembourg(LU)**

## Description

The invention herein is directed toward the technology of electronic packaging, and particularly toward electronic printed circuit board or card retainers in electronic packages.

Closely spaced electronic components on printed circuit boards arranged in parallel in an electronic chassis require an environment in which the temperature is controlled below a selected level. The prior art has recognized the advantage of conducting some of the heat generated by the electronic components away through a heat sink upon which the printed circuit board is mounted. Significant cooling is thus achieved by establishing a thermal conduction path from the electronic card through its heat sink to a heat exchanger in the chassis holding the card. This thermal path extends from the actual components on the card through a bond line attaching it to a chem-milled aluminum heat sink. The heat sink is held in place by a card retainer in the chassis through which heat is conducted to the chassis wall and finally to the heat exchanger. The thermal resistance through the card retainer is a significant portion of the overall thermal resistance. Various approaches have been suggested in the prior art for minimizing the thermal resistance in the retainer. Among the prior art approaches to card retainers are included multi-wedge card retainers as exemplified in various U. S. Patents including each of the following.

US-A-4,298,904 discloses means for clamping a printed circuit board to a chassis with improved heat transfer. The chassis, which acts as a heat sink, is provided with elongated slots which receive the opposite edges of a heat sink sandwiched between insulating printed circuit layers of the printed circuit card. Disposed within each slot is a plurality of wedges which, when tightened, make contact with three surfaces thereby providing a means for contacting an additional surface, since the prior art wedges only made contact with two surfaces. Thus, heat conduction is improved and temperature is reduced. The wedge-shaped elements are spaced along the shank of a screw which threads into a threaded hole extending through the last of the wedge-shaped elements such that when the screw is turned, the elements are drawn together or separated, depending on the direction of rotation of the screw. The facing end surfaces of the wedge-shaped elements are slanted in two directions, preferably along 45° angles. In this manner, as the wedge-shaped elements are drawn together, they tend to spread apart along a 45° angle whereby contact is made with two surfaces at right angles to each other. See column 3, lines 59-68 and column 4, lines 1-3 for a detailed description of the movement of the elements as the screw is tightened.

US-A-4,318,157 discloses apparatus for mounting a printed circuit card to a chassis adapted to support an array of circuit cards. In this case, the card itself carries a plurality of wedges or "ramps" held together by a long screw. Adjacent ramps have oblique and parallel mating surfaces such that tightening the screw moves adjacent ramps in opposite directions laterally which causes alternate ramps and the circuit card against opposing channel walls in the chassis to frictionally secure the circuit card in the chassis. The disclosure recognizes the importance of heat dissipation and indicates that the use of ramps maximizes the transfer of heat from each circuit card to the chassis. See column 5, lines 40-68 and column 6, lines 1-6 for a discussion of the clamping action.

US-A-4,414,605 discloses a mechanism for securing a plug-in electronic module in a chassis. Again, a threaded screw is passed through a plurality of wedges carried on a printed circuit board. The difference, in this case, is that a need was seen to insure that there is positive visual indication as to whether or not the wedges have been moved to their desired position and also the desirability of eliminating the need for special tools which may be easily lost and which may not be available when needed. The locking mechanism consists of a threaded screw similar to the long screws used in the prior art except that a pivotal driver blade is provided for turning the threaded element. After the threaded element is fully engaged in the tapped hole, the driver blade is pivoted and a cam thereon actuates the wedges which engage the electronic printed circuit board and the chassis to provide a good thermal interface. A spring 38 is positioned between a spring compressor 37 and the top of wedge 23.

US-A-4,480,287 discloses an improved electronic circuit module retainer apparatus having interlocking, wedge-shaped components which are slotted and keyed together to prevent the wedges from turning out of position when the longitudinal screw is not tightened.

All of these prior art retainers provide improved heat transfer. Except US-A-4,414,605 all require a tool for torquing down a bolt for supplying compression. If the tool is not available, if the technician forgets to tighten the bolt, or if, as in US-A-4,414,605 the blade is not pivoted, there is no good thermal contact whatsoever.

The object of the invention is to provide an improved printed circuit board heat sink retainer which does not require torquing and which eliminates wedge rotation when the heat sink is not present.

According to the present invention, to achieve this, there is provided a printed circuit board (PCB) heat sink retainer for retaining a heat sink in a rectangular open-sided channel having opposite side walls, said retainer comprising a plurality of trapezoidal wedges of rectangular cross-section each wedge having slanted end faces which are forced against and slidably engage similarly slanted end faces of adjacent wedges alternately flipped for such engagement, said wedges being aligned end-to-end within the channel with a long side of a wedge facing, for engagement with, a channel side wall opposite the channel side wall faced by a long side of the next adjacent wedge, and means for slidably forcing the ends of the wedges against one another thereby causing oppositely directed lateral movement of alternate wedges and forcing one set of alternate wedges against a heat sink inserted between the wedges and one of the channel side walls and the other remaining set of alternate wedges against the other opposite side wall of the channel, whereby the heat sink will be held firmly in place, characterized in that said plurality of wedges include an entrance top wedge fixed in position at the end of the channel of initial PCB heat sink insertion, and that said forcing means comprises a spring, one end of which acts against the other end of the channel and the other end of the spring acts against a moveable bottom end wedge of said plurality of wedges at the other end of the channel for providing a preinsertion force such that prior to the insertion of PCB heat sink alternate wedges are biased in opposite directions towards the opposite channel side walls and such that, upon insertion of a PCB heat sink part of the spring force will be transmitted to and exerted by said one set of wedges against the fully inserted heat sink and part of the spring force will be transmitted to and exerted by the other set of wedges against the other channel side wall to thereby hold the heat sink firmly in place in the absence of any torquing.

The entrance wedge may be torqued down using a set screw held in place with respect to the chassis.

Each of the plurality of wedges may have an oversized bore or a slot for receiving a wire which extends from one end of the channel to the other through the wedges. The wire may be anchored in each end of the channel for loosely holding the wedges in longitudinal alignment and for preventing wedges from falling out of the channel.

The edges at the ends of the longest side of each trapezoidal wedge may be chamfered. In lieu of chamfering both edges, only the edge closest to the entrance wedge of each trapezoidal wedge (for initial contact with a heat sink being inserted) may be chamfered.

The spring loaded feature of the multi-wedge card retainer disclosed herein provides improvements to the existing art. The areas of application that are aided most by this improvement are related to assembly and repair of electronic equipment. As in many industries where equipment needs repair, here also, human error accounts for a certain percentage of equipment failure. In the case of the multi-wedge card retainer, the device is only effective if the service personnel torques the set screw. If the set screw is not secured during servicing, a poor thermal conduction path from the printed circuit board to the chassis exists. This, in turn, causes the electrical component temperatures of the PCB to exceed design limits. Eventually, one or more of these electrical components will fail, causing the equipment to be pulled out of service. The spring loaded feature significantly decreases the occurrences of this type of failure. In addition, the present invention teaches that placement of the spring at the bottom of the channel eases insertion of the PCB, which would he considerably more difficult if the spring were located at the top of the channel. In addition, twisting of wedges in the absence of a PCB is prevented.

These and other features and advantages of the heat sink retainer will become more apparent in light of the detailed description of a best mode embodiment thereof, as illustrated in the accompanying drawing, wherein:

Fig. 1 is an illustration of a spring-loaded multi-wedge card retainer;

Fig. 2 is an illustration of the spring-loaded bottom wedge in the channel of Fig. 1 shown in the free position;

Fig. 3 is an illustration similar to Fig. 2 except that the wedges are shown in the torqued position; and

Fig. 4 is a section view of a channel in a chassis wall along lines 4-4 of Fig. 1.

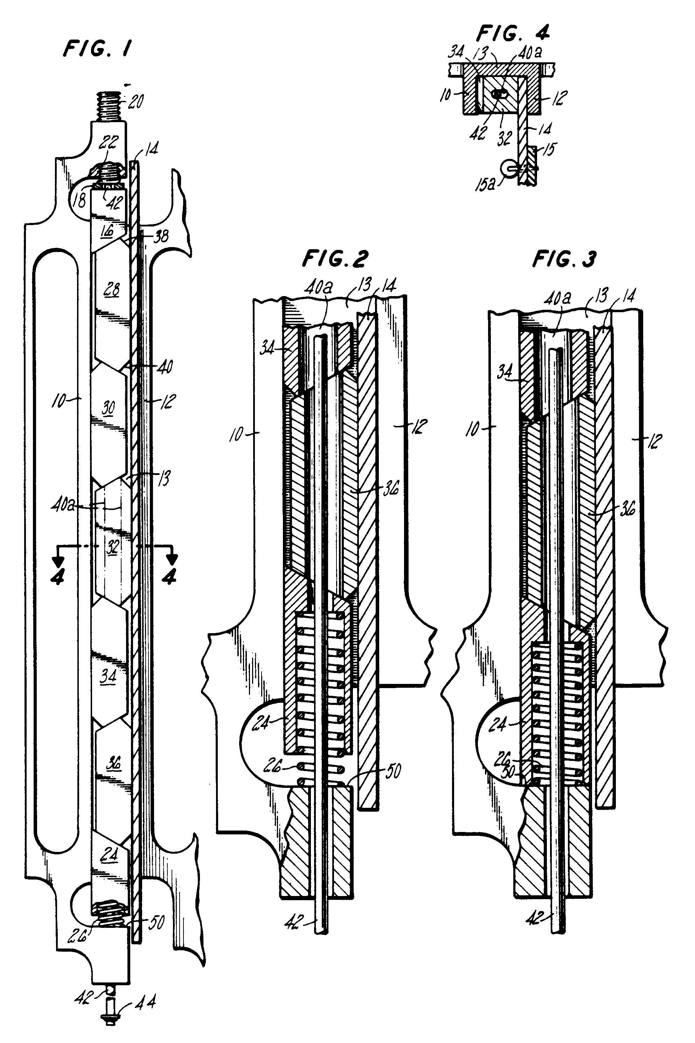

Referring to Fig. 1 of the drawing, a spring-loaded multi-wedge PCB retainer is illustrated. A plurality of rectangular, tubular channels are machined into the chassis walls. Each channel has a pair of opposing walls 10, 12 joined at the back of the channel by another wall 13 shown in Fig. 4 as part of the chassis. Thus, the rectangular channel has a "C" shaped cross-section with one open side for receiving a PCB heat sink 14 shown in cross-section in both Figs. 1 and 4. Fig. 4 additionally shows a printed circuit board 15 and a typical electronic component 15a attached thereto.

A plurality of wedges are shown in Fig. 1 aligned end-to-end within the channel. A top wedge 16 includes a bearing washer 18 attached to the top thereof for bearing against a set screw 20 which is threaded into a threaded part 22 of the chassis, which may be machined out of the chassis at the same time as the channels. The bearing washer 18 may be of steel while the wedge 16 may be of aluminum so that a steel set screw will be able to bear on the top wedge without cutting into the softer aluminum. The set screw 20 may be torqued down with an Allen wrench or any other similar type tool which would be readily available to an electronics technician.

A bottom wedge 24 sits at the bottom of the channel. It is open ended at the bottom-most end and contains a cavity for receiving a compression spring 26 which extends out of the bottom of the wedge in the untorqued or free position of the apparatus.

A plurality of intermediate wedges 28, 30, 32, 34, and 36 are aligned end-to-end between the top wedge 16 the bottom wedge 24. Each wedge consists of a long rectangular tube, which may be square, having two opposing rectangular faces and two opposing congruent trapezoidal faces formed by slant cuts at the ends of each wedge forming end faces which mate with similarly slanted end faces of adjacent wedges in the channel. The angles may be of any convenient slant but are preferably of a slant of approximately 60°, but which may be in the range of approximately 45° to 75°. Adjacent wedges are in "flipped" relation to one another. In other words, the long retangular faces of alternate wedges bear against the same channel wall. For example, the long rectangular faces of wedges 28, 32, and 36 bear against channel wall 12 (in the absence of an inserted heat sink 14) while the long rectangular faces of wedges 30 and 34 bear against channel wall 10.

The edges 38, 40 of each wedge at the ends of each long rectangular face may be chamfered in order to facilitate insertion of the heat sink 14. Although it would only be necessary to chamfer edge 38 in order to thus facilitate entry of the heat sink, it would be easier, manufacturing-wise, to chamfer both ends of the long face. Then there would be no unnecessary confusion during assembly of chamfered versus non-chamfered edges. It would also be unnecessary to have chamfered edges on wedges 30, 34 but, for manufacturing and assembling simplicity, it is easier to just manufacture all the wedges identically. Of course, it is within the spirit and scope of this aspect of the invention to chamfer the first edge of each wedge which comes into contact with a heat sink being inserted and any variations of chamfering which include this aspect of the invention.

Each wedge may have a longitudinal slot or an oversized bore, including the end wedges, which may have either an oversized longitudinal counterbore, a simple oversized bore or slot as shown in phantom lines 40a for receiving a wire 42 which extends along the entire length of the stacked wedges and which holds the wedges in place so that the wedges do not fall out of the channel. The wedge retaining wire 42 is terminated in the set screw 20 and has a wire retaining washer 44 attached to the other end.

It is an important teaching of the present invention that, in the absence of any torquing by an electronics technician, any PCB circuit board inserted between the plurality of wedges and channel wall 12 will be held firmly in place anyway by the compression force provided by spring 26. The spring pushes wedge 24 upwardly against the bottom slant face of wedge 36 which thereby has its long rectangular face forced up against the heat sink 14 by virtue of the transmission of this compression spring force along the entire line of wedges all the way to the top wedge 16. Each successive wedge is forced alternately against either the heat sink or the other channel wall 10 by virtue of the sliding engagement of each end face of each wedge causing lateral movement in opposite directions of each alternate wedge. Thus, wedges 36, 32, and 28 bear up against heat sink 14 while wedges 30, 34 bear up against channel wall 10. Even in the absence of the insertion of a heat sink, the individual wedges are still forced up against or close to opposite sidewalls 10, 12 of the channel. It will be seen by reference to Fig. 2, that if the heat sink 14 were removed, wedge 36 would not quite make contact with channel wall 12 before being held back by wire 42. However, if the slot or bore in wedge 36 were large enough, then the wedge would make contact with wall 12. Thus, the wedges are in a permanent state of compression and are held in place by virtue of this compression combined with the presence of the retaining wire 42. There is thus no tendency for the wedges to get inadvertently turned around in the wrong direction or to fall out of the channel once they are set up correctly during initial assembly.

The spring is at the lower end of the channel since this aids in easy insertion of the PCB heat sink. If the compression spring were instead in top end wedge 16, the insertion of the heat sink would be considerably more difficult. This is due in part to the fact that the wedges would be forced to expand upwardly against the direction of the inserting heat sink. Additionally, more wedges would be forced to expand upwardly as the heat sink nears the final stage of insertion. When the heat sink makes contact with the chamfer of wedge 36, wedge 36 will in turn force wedges 34, 32, 30, 28 and 16 to be forced upwards against the force of the compression spring. There is considerably more frictional resistance associated with this insertion as compared to the spring located at the bottom where only wedge 36 and 24 are forced to expand longitudinally during the final stage of heat sink insertion.

Referrring now to Fig. 2, an enlarged view of the illustration of Fig. 1, near the bottom end of the channel is shown. The wedges are in an untorqued, "free" position, where the electronics technician has not yet torqued down the set screw 20 of Fig. 1. As may be seen from the position of the end wedge 24, the compression spring 26 extends out of the cavity within end wedge 24. In that case, the long rectangular face of wedge 36 bears up against heat sink 14 by virtue of the spring force provided by compression spring 26. Similarly, the long face of wedge 34 bears up against channel wall 10 by virtue of the transmission of this spring force from wedge 36 along the top slanted face thereof. It will be observed that additional and stronger compressive forces may be supplied by torquing down the set screw 20 of Fig. 1 and forcing the end wedge 24 to occupy a lower position within the channel as shown in Fig. 3. In Fig. 3, all of the other wedges have also slid down into the channel and moved further apart laterally so as to increase the compressive forces exerted against the channel walls, thereby increasing the heat transfer capabilities of the heat sink channel wall 12 interface. With the bottom wedge 24 seated at the bottom of the channel against end piece 50, it is evident that additional compressive forces exerted by torquing down the set screw after this point will provide much increased lateral compression with a resulting greatly increased heat transfer. Of course, there is also heat transfer capability provided between channel wall 10 and the long faces of wedges 34 and 30, although this is not as significant as the interface provided by wedges 28, 32, and 36.

## Claims

1. A printed circuit board (PCB) heat sink retainer for retaining a heat sink (14) in a rectangular open-sided channel having opposite side walls (10, 12), said retainer comprising a plurality of trapezoidal wedges (16, 24 and 28-36) of rectangular cross-section each wedge having slanted end faces which are forced against and slidably engage similarly slanted end faces of adjacent wedges alternately flipped for such engagement, said wedges (16, 24 and 28-36) being aligned end-to-end within the channel with a long side of a wedge facing, for engagement with, a channel side wall (10, 12) opposite the channel side wall (10, 12) faced by a long side of the next adjacent wedge, and means for slidably forcing the ends of the wedges (16, 24 and 28-36) against one another thereby causing oppositely directed lateral movement of alternate wedges and forcing one set of alternate wedges against a heat sink (14) inserted between the wedges and one (12) of the channel side walls (10, 12) and the other remaining set of alternate wedges against the other opposite side wall (10) of the channel, whereby the heat sink (14) will be held firmly in place, characterized in that said plurality of wedges (16, 24 and 28-36) include an entrance top wedge (16) fixed in position at the end of the channel of initial PCB heat sink (14) insertion, and that said forcing means comprises a spring (26), one end of which acts against the other end of the channel and the other end of the spring (26) acts against a moveable bottom end wedge (24) of said plurality of wedges (16, 24 and 28-36) at the other end of the channel for providing a preinsertion force such that prior to the insertion of the PCB heat sink (14) alternate wedges (16, 24 and 28-36) are biased in opposite directions towards the opposite channel side walls (10, 12) and such that, upon insertion of a PCB heat sink (14) part of the spring force will be transmitted to and exerted by said one set of wedges against the fully inserted heat sink (14) and part of the spring force will be transmitted to and exerted by the other set of wedges (16, 24 and 28-36) against the other channel side wall (10) to thereby hold the heat sink (14) firmly in place in the absence of any torquing.

2. Retainer according to claim 1, characterized by means for applying additional longitudinal compressive forces upon said wedges (16, 24 and 28-36), for use after a heat sink (14) is inserted between said one channel side wall (12) and said wedges.

3. Retainer according to claim 1, characterized in that the end wedge (24) disposed at the other end of the channel has a cavity therein, and that said spring (26) is a compression spring for insertion in said cavity.

4. Retainer according to claim 1, characterized in that each of said plurality of wedges (16, 24 and 28-36) has an oversized slot or bore (40a) for receiving a wire (42) which extends from one end of the channel to the other through said wedges, said wire (42) being anchored in each end of the channel for loosely holding said wedges in longitudinal alignment and for preventing wedges from falling out of the channel.

5. Retainer according to claim 1, characterized in that an edge of at least alternate wedges (28, 32, 36) is chamfered at least at the end closest to said fixed wedge (16) at the end of the channel where the PCB heat sink is first inserted.

6. Retainer according to claim 1, characterized in that said entrance wedge (16) is settable to various fixed positions so as to provide the capability, by adjusting the position of the entrance wedge (16), of exerting additional compressive forces on said plurality of wedges (16, 24 and 28-34) after said PCB heat sink (14) is inserted between said channel and said wedges.

7. Retainer according to claim 6, characterized in that the position of said entrance wedge (16) is settable by means of a set screw (20) fixed in place with respect to the channel.

**Revendications**

1. Dispositif de maintien d'un radiateur thermique pour une carte de circuit imprimé (PCB) pour maintenir un radiateur thermique (14) dans un passage rectangulaire à deux montants comportant des parois latérales opposées (10), 12), ledit moyen de maintien comprenant une pluralité de coins trapézoïdaux (16, 24 et 28 à 36) de section transversale rectangulaire, chaque coin ayant des faces d'extrémité inclinées qui sont forcées contre et engagent de manière coulissante avec les faces d'extrémité similairement inclinées des coins adjacents ou bien sont manoeuvrées pour un tel engagement, lesdits coins (16, 24 et 28 à 36) étant alignés bout à bout à l'intérieur du passage avec un côté long d'un coin faisant face, pour engagement avec une paroi latérale du passage (10, 12) opposée à la paroi latérale du passage (10, 12) faisant face à un côté long du prochain coin contigu et des moyens pour forcer de manière coulissante les extrémités des coins (16, 24 et 28 à 36) l'une contre l'autre provoquant de ce fait un déplacement latéral dirigé de manière opposée des coins alternés et forçant un ensemble de coins alternés contre un radiateur thermique (14) introduit entre les coins et une paroi (12) des parois latérales du passage (10, 12) et formant l'autre ensemble restant des coins alternés contre l'autre paroi latérale opposée (10) du passage, si bien que le radiateur thermique (14) sera maintenu fermement en place, caractérisé en ce que ladite pluralité de coins (16, 24 et 28 à 36) comporte un coin d'entrée au sommet (16) fixé en position a l'extrémité du passage d'introduction initiale du radiateur thermique de la carte de circuit imprimé et en ce que ledit moyen de forçage comprend un ressort (26) dont une extrémité agit contre l'autre extrémité du passage et l'autre extrémité du ressort (26) agit contre un coin d'extrémité inférieur déplaçable (24) de ladite pluralité de coins (16, 24 et 28 à 36) a l'autre extrémité du passage pour procurer une force de pré-introduction telle qu'avant l'introduction du radiateur thermique de la carte de circuit imprimé (14), les coins alternées (16, 24 et 28 a 36) sont sollicités dans des directions opposées vers les parois latérales opposées du passage (10, 12) et d'une manière telle que, sur introduction du radiateur thermique de la carte de circuit imprimé, une partie de la force de ressort sera communiquée à et exercée par ledit premier ensemble de coins contre le radiateur thermique totalement introduit (14) et une partie de la force du ressort sera communiquée à et exercée par l'autre ensemble de coins (16, 24 et 28 à 36) contre l'autre paroi latérale du passage (10) pour maintenir de ce fait fermement en place le radiateur thermique (14) en l'absence de toute torsion.

2. Dispositif de maintien selon la revendication 1, caractérisé par des moyens pour appliquer des forces de compression supplémentaires longitudinales sur lesdits coins (16, 24 et 28 a 36), pour utilisation après qu'un radiateur thermique (14) soit introduit entre ladite paroi latérale du canal (12) et lesdits coins.

3. Dispositif de maintien selon la revendication 1, caractérisé en ce que le coin d'extrémité (24) disposé à l'autre extrémité du passage présente une cavité dans celui-ci et que ledit ressort (26) est un ressort à compression pour introduction dans ladite cavité.

4. Dispositif de maintien selon la revendication 1, caractérisé en ce que chaque coin de ladite pluralité de coins (16, 24 et 28 à 36) présente une fente ou alésage surdimensionné (40a) pour recevoir un câble (42) qui s'étend depuis une extrémité du passage a l'autre à travers lesdits coins, ledit câble (42) étant amarré à chaque extrémité du passage pour maintenir faiblement lesdits coins en alignement longitudinal et pour empêcher les coins de sortir du passage.

5. Dispositif de maintien selon la revendication 1, caractérisé en ce qu'un bord d'au moins les coins alternés (28, 32, 36) est chanfreiné à une extrémité la plus proche dudit coin fixe (16) à l'extrémité du passage où le radiateur thermique de la carte de circuit imprimé est tout d'abord introduit.

6. Dispositif de maintien selon la revendication 1, caractérisé en ce que le coin d'entrée (16) est positionnable à diverses positions fixes de façon à donner la possibilité en réglant la position du coin d'entrée (16) d'exercer des forces de compression supplémentaires sur ladite pluralité de coins (16, 24 et 28 à 36) après que ledit radiateur thermique de la carte de circuit imprimé (14) soit introduit entre ledit passage et lesdits coins.

7. Dispositif de maintien selon la revendication 6, caractérisé en ce que la position dudit coin d'entrée (16) est positionnable au moyen d'une vis de réglage (20) fixée en place par rapport au passage.

**Patentansprüche**

1. Leiterplatten (PCB)-Kühlkörperhalter zum Haltern eines Kühlkörpers (14) in einem rechteckigen, offenseitigen Kanal, welcher entgegengesetzte Seitenwände (10, 12) hat, wobei der Halter eine Anzahl von trapezförmigen Keilen (16, 24 und 28-36) rechteckigen Querschnittes aufweist, wobei jeder Keil geneigte Endflächen hat, die gegen ähnlich geneigte Endflächen von benachbarten Keilen gedruckt werden und diese verschiebbar berühren, welche für diese Berührung abwechselnd geflippt werden, wobei die Keile (16, 24 und 28-36) Ende an Ende in dem Kanal ausgerichtet sind, wobei eine Längsseite eines Keils einer Kanalseitenwand (10, 12) zur Berührung mit derselben zugewandt ist, welche der Kanalseitenwand (10, 12) gegenüberliegt, der eine Längsseite des nächsten benachbarten Keils zugewandt ist, und eine Einrichtung zum verschiebbaren Drücken der Enden der Keile (16, 24 und 28-36) gegen einander, wodurch eine entgegengesetzt gerichtete Querbewegung von abwechselnden Keilen bewirkt wird und ein Satz abwechselnder Keile gegen einen Kühlkörper (14) gedrückt wird, der zwischen die Keile und eine (12) der Kanalseitenwände (10, 12) eingeführt ist, und der andere, übrige Satz abwechselnder Heile gegen die andere, entgegengesetzte Seitenwand (10) des Kanals, wodurch der Kühlkörper (14) fest in seiner Lage gehalten wird, dadurch gekennzeichnet, daS die Anzahl von Heilen (16, 24 und 28-36) einen oberen Eingangskeil (16) aufweist, der in seiner Position an dem Ende des Kanals am Anfang des Einführens des Leiterplattenkühlkörpers (14) fixiert ist, und daß die Drückeinrichtung eine Feder (26) aufweist, von welcher ein Ende auf das andere Ende des Kanals einwirkt und das andere Ende der Feder (26) auf einen beweglichen unteren Endkeil (24) der Anzahl von Keilen (16, 24 und 28-36) an dem anderen Ende des Kanals einwirkt, um eine Voreinführkraft zu erzeugen, so daS vor dem Einführen des Leiterplattenkühlkorpers (14) abwechselnde Heile (16, 24 und 28-36) in entgegengesetzten Richtungen zu den entgegengesetzten Kanalseitenwänden (10, 12) hin vorgespannt sind und daß bei dem Einführen eines Leiterplattenkühlkörpers (14) ein Teil der Federkraft auf den einen Satz Heile übertragen und durch diesen auf den vollständig eingeführten Kühlkörper (14) ausgeübt wird und ein Teil der Federkraft durch den anderen Satz Heile (16, 24 und 28-36) auf die andere Kanalseitenwand (10) übertragen und auf diese ausgeübt wird, um dadurch den Kühlkörper (14) in Abwesenheit jeglichen Drehmoments fest in seiner Lage zu halten.

2. Halter nach Anspruch 1, gekennzeichnet durch eine Einrichtung zum Ausüben von zusätzlichen Längsdruckkräften auf die Keile (16, 24 und 28-36) zur Verwendung, nachdem ein Kühlkörper (14) zwischen die eine Kanalseitenwand (12) und die Keile eingeführt worden ist.

3. Halter nach Anspruch 1, dadurch gekennzeichnet, daß der Endkeil (24), der an dem anderen Ende des Kanals angeordnet ist, einen Hohlraum aufweist und daß die Feder (26) eine Druckfeder zum Einführen in den Hohlraum ist.

4. Halter nach Anspruch 1, dadurch gekennzeichnet, daß von der Anzahl von Keilen (16, 24 und 28-36) jeder einen überdimensionierten Schlitz oder eine überdimensionierte Bohrung (40a) zum Aufnehmen eines Drahtes (42) hat, der sich von einem Ende des Kanals zu dem anderen durch die Keile erstreckt, wobei der Draht (42) in jedem Ende des Kanals verankert ist, um die Heile locker in Längsausrichtung zu halten und zu verhindern, daß Keile aus dem Kanal herausfallen.

5. Halter nach Anspruch 1, dadurch gekennzeichnet, daß ein Rand von wenigstens abwechselnden Keilen (28, 32, 36) wenigstens an dem Ende abgeschrägt ist, das dem fixierten Keil (16) an dem Ende des Kanals, wo der Leiterplattenkühlkörper zuerst eingeführt wird, am nächsten ist.

6. Halter nach Anspruch 1, dadurch gekennzeichnet, daß der Eingangskeil (16) in verschiedene fixierte Positionen einstellbar ist, um so die Möglichkeit zu schaffen, durch Justieren der Position des Eingangskeils (16) zusätzliche Druckkräfte auf die Anzahl von Keilen (16, 24 und 28-36) ausüben zu können, nachdem der Leiterplattenkühlkörper (14) zwischen den Kanal und die Keile eingeführt worden ist.

7. Halter nach Anspruch 6, dadurch gekennzeichnet, daß die Position des Eingangskeils (16) mittels einer Einstellschraube (20) einstellbar ist, deren Lage in bezug auf den Kanal fest ist.

FIG. 1

FIG. 4

FIG. 2

FIG. 3